# EUROPÄISCHE PATENTSCHRIFT

(11) **EP 2 664 723 B1**
(45) Veröffentlichungstag und Bekanntmachung des Hinweises auf die Patenterteilung: **27.12.2017**
(21) Anmeldenummer: 13174606.7
(22) Anmeldetag: 17.07.2009
(51) Int. Cl.: E04B 1/90, E04B 1/92, F24D 3/14, E04B 1/14, H05K 9/00

(54) **Wandelement für ein Gebäude**
Wall element for a building
Elément d'un mur pour un bâtiment

(43) Veröffentlichungstag der Anmeldung: 20.11.2013
(62) Teilanmeldung aus: 09775750.4
(73) Patentinhaber: Stone Treuhand AG, 8008 Zürich (CH)
(72) Erfinder: Hillers, Guillaume Eugène, 8404 Stadel (CH)
(74) Vertreter: Schneider Feldmann AG Patent- und Markenanwälte

(56) Entgegenhaltungen:
- EP-A2- 0 191 144
- WO-A1-2005/121469
- US-A- 5 491 945

## Beschreibung

Die vorliegende Erfindung betrifft das technische Gebiet der Gebäudekonstruktion und insbesondere ein vorgefertigtes Wandelement nach Anspruch 1.

Aus der Patentschrift NL 8902670 ist bereits eine Gebäudestruktur mit einem Schaummaterial-Fundament und einer darauf errichtete Holzgerüst-Stützkonstruktion bekannt. Diese ist mit Frontpaneelen aus einem Schaummaterial verkleidet, die mit einem teilweise darin eingebetteten Metalldrahtgitter verstärkt sind.

Die internationale Patentanmeldung WO 2005/121469 zeigt eine Gebäudekomponente aus einem Schaummaterial, in das ein räumlich strukturiertes Verstärkungsnetz wenigstens teilweise eingebettet ist. Die von dem Schaummaterial abstehenden Netzteile werden zum Verankern einer Putzschicht genutzt.

Aus EP 0191144 ist ein plattenförmiger Baukörper zur Erstellung und Verkleidung von Mauern, Wänden und Fassaden bekannt. Der Baukörper umfasst mehrere Gasbetonplatten und eine Wärme-, Kälte- und Schallisolationsschicht, wobei beide Teile durch eine Klebschicht auf Zementbasis miteinander flächig verbunden sind und in die Klebschicht ein zähelastisches, metallfreies, korrosionsfestes Gewebe eingebettet ist. Mehrere solche plattenförmigen Baukörper können mittels Schrauben beidseitig auf einer Tragekonstruktion aus Holz bzw. Metall befestigt werden.

Es ist Aufgabe der vorliegenden Erfindung, die bekannten Wandstrukturen zu verbessern, insbesondere ihre Belastbarkeit, ihre Wärme -, Schall und Strahlungsdämmung bei gleichzeitig einfachem konstruktivem Aufbau und leichter wie kostengünstiger Herstellbarkeit zu erhöhen.

Diese Aufgabe wird durch ein Wandelement gemäß Anspruch 1 gelöst, wobei das Wandelement einen ersten plattenförmigen Stützkörper aus einem massiven Schaummaterial aufweist, dessen zum Gebäudeinneren auszurichtende Oberfläche an eine Isolationsschicht angrenzt, und ein erstes wellenförmig ausgebildetes Metalldrahtgitter, das wenigstens teilweise in eine zum Gebäudeäusseren auszurichtenden Oberfläche des ersten Stützkörpers eingeschäumt ist, sowie erste Befestigungselemente, die sowohl das erste Gitter als auch den ersten Stützkörper durchgreifen, um Stützelemente zu befestigen, zwischen denen die Isolationsschicht aufgenommen ist.

Ein wesentlicher Punkt der erfindungsgemässen Struktur besteht zunächst darin, dass deren üblicherweise geforderte Belastbarkeit allein durch den ersten Stützkörper in Verbindung mit dem darin wenigstens teilweise eingebetteten ersten Metalldrahtgitter gewährleistet ist. Das erste wellenförmige Gitter wirkt dabei derart stabilisierend, dass Spannungen, die durch auf den Stützkörper einwirkende statische oder dynamische Lasten entstehen, gleichmassig über diesen hinweg verteilt werden. Die erfindungsgemässe Struktur erweist sich deshalb auch als besonders erdbebenresistent, aber auch resistent gegen seitliche Krafteinwirkung. Durch das erste Gitter werden weiterhin Strahlungen vom Gebäudeinneren ferngehalten, wie sie z.B. von Hochspannungsleitungen, Telekommunikationsanlagen, radioaktiven Quellen o.Ä. ausgehen. Gleichzeitig dient das erste Gitter dazu, die Befestigungselemente sicher in ihrer Position zu halten, so dass diese nicht verrutschen und eine stabile Aufnahme der Isolationsschicht gewährleistet ist. Der Stützkörper kann aus einem Polyurethan-Schaum mit einer Kieseinlage bestehen, die hohe Druckresistenz, eine kapillare Wasserabsorption, eine unidirektionale Stabilität und eine gute Durchlässigkeit für Wasserdampf aufweist. Durch die gute Wärmeleitfähigkeit des ersten Gitters wird zudem verhindert, dass sich eine derart strukturierte Wand leicht aufheizt, da die aufgenommene Wärme über das Gitter abgeleitet wird. In Zusammenhang mit der Isolationsschicht entsteht damit eine besonders gute Wärme- und Schalldämmung z.B. gegen eine Verbindung aus heisser und zudem lauter Umgebung. Die beschriebene Wandstruktur ist ausserdem besonders einfach und kostengünstig herstellbar, z.B. durch vollautomatisierte Platzierung der Befestigungselemente an jeder gewünschten Stelle des Stützköpers, unabhängig z.B. von vorgegebenen Bohrlöchern.

Bevorzugte Weiterbildungen der erfindungsgemässen Wandstruktur sind in den Unteransprüchen angegeben. Diese betreffen insbesondere Dämmungs- und Stabilitätsaspekte sowie Ausstattungsdetails.

In einer vorteilhaften Ausführungsform ist es vorgesehen, dass die Struktur eine Innenverkleidung aufweist, welche an eine zum Gebäudeinneren auszurichtende Oberfläche der Isolationsschicht angrenzt, und mit zweiten Befestigungselementen versehen ist, welche die Innenverkleidung durchgreifen, um diese an den Stützelementen zu befestigen. Die Stützelemente können damit nicht nur der Aufnahme der Isolationsschicht, sondern auch zur Befestigung der Innenverkleidung genutzt werden, und bilden damit ein einheitliches Befestigungssystem. Gleichzeitig stellt die Innenverkleidung eine weitere Isolationsschicht dar. Damit kann eine Wandstruktur mit bereits vormontierter Innenverkleidung geliefert werden, so dass eine diesbezügliche Montage auf der Baustelle (on site) entfällt. Im einfachsten Fall kann die Innenverkleidung Gipskartonplatten umfassen, die später mit einer individuellen Beschichtung (Tapete, Farbe o.Ä) versehen werden.

Bevorzugt ist es allerdings, wenn die Innenverkleidung einen zweiten plattenförmigen Stützkörper aus einem massiven Schaummaterial umfasst, der angrenzend zu der Isolationsschicht angeordnet ist. Damit erhöht sich die Belastbarkeit der Wandstruktur bei zudem steigender Wärme- und Schalldämmung erheblich. Bevorzugt umfasst die Innenverkleidung ein zweites wellenförmig ausgebildetes Metalldrahtgitter, das wenigstens teilweise in eine zum Gebäudeinneren auszurichtende Oberfläche des zweiten Stützkörpers eingeschäumt ist. Dadurch verstärken sich die Vorteile, die schon im Zusammenhang mit dem ersten Metalldrahtgitter genannt wurden. Insbesondere verhindert auch das zweite Gitter, dass sich die Wand aufwärmt, so dass eine gute Wärmedämmung gegen eine kalte Umgebung entsteht. Es ist dabei denkbar, die Schichtung der erfindungsgemässen Wandstruktur anforderungsabhangig beliebig zu wiederholen, d. h. auf den zweiten Stützkörper (mit zweitem Gitter) wiederum eine Isolationsschicht folgen zu lassen und auf diese wiederum einen dritten Stützkörper (mit drittem Gitter) usw..

Bevorzugt weist eine solche Innenverkleidung eine Innenputzschicht auf, die auf der zum Gebäudeinneren auszurichtenden Oberfläche des zweiten Stützkörpers aufgebracht und an dem zweiten Metalldrahtgitter verankert ist. Über das zweite Gitter ist damit ein besonders sicherer Halt der Innenputzschicht an dem zweiten Stützkörper gewährleistet. Durch die besonders gute Spannungsverteilung in den zweiten Stützkörper eingeleiteter Lasten wird ausserdem eine Rissbildung im Putz sicher ausgeschlossen.

Bei Anbringung einer Innenverkleidung ist es weiterhin bevorzugt, eine dampfdurchlässige Folie anzubringen, die sich zwischen der Isolationsschicht und der Innenverkleidung erstreckt. Damit wird Schwitzwasser, dass sich zwangsläufig bei Temperaturwechseln in der Isolationsschicht bildet, aus diesem Raum entweichen kann. Damit ist eine Durchfeuchtung der Wand von innen her ausgeschlossen.

Ähnlich der Innenverkleidung kann auch eine Aussenverkleidung vorgesehen sein, die an eine zum Gebäudeäusseren auszurichtende Oberfläche der ersten Stützschicht angrenzt, und die eine Aussenputzschicht umfasst, welche an dem ersten Metalldrahtgitter verankert ist. Eine solche Aussenputzschicht bedeckt dabei vollständig das erste wellenförmige Metalldrahtgitter und verhindert ebenfalls ein Aufheizen der Wandstruktur. Zudem wirkt der Aussenputz feuchtigkeitsabweisend und ist zudem frost- und schockresistent . Grundsätzlich kann die Aussenverkleidung aber auch aus einer Mörtelschicht bestehen, welche das erste Gitter bedeckt, und die wiederum Zierplatten trägt.

Wandstrukturen, die höchsten Belastungen ausgesetzt sind, weisen bevorzugt ein jeweiliges dreidimensionales Metalldrahtgitter auf, das vollständig in den ersten und/oder zweiten Stützkörper eingeschäumt ist. Damit wird die Belastungsfähigkeit der Wandstruktur noch einmal deutlich erhöht. Die Isolationsschicht besteht in bevorzugter Weise aus einem Mineralwollmaterial, das die einfachste und wirksamste Wärme- und Schalldämmung darstellt, die noch dazu kostengünstig ist.

Eine besonders leicht zu montierende und haltbare Befestigung der Stützelemente ergibt sich, wenn die ersten und/oder zweiten Befestigungselemente aus einer jeweiligen Schrauben- und Widerlagerkombination bestehen. Das Widerlager kann im einfachsten Fall aus einer Gewindemutter bestehen, die gegen einen Teil des Stützelements angezogen wird und so das Element in Position halt. Denkbar sind aber auch platten- oder blockförmige Lager mit darin angebrachten Gewindelochern, die eine möglichst grosse Fixierungsfläche zulassen.

Noch einfacher zu montieren ist allerdings eine jeweilige Schrauben- und Widerlagerkombination, die eine selbstschneidende Schraube und ein Widerlager aus einem Kunststoff-material umfasst. Dabei entfällt eine genaue Ausrichtung beider Teile auseinander, insbesondere dann, wenn das Widerlager platten- oder blockförmig ausgeprägt ist.

Um eine besonders stabile Befestigung der Stützelemente zu erzielen, ist der Kopfdurchmesser einer jeweiligen Schraube bevorzugt grosser als die Maschenweite des ersten bzw. zweiten Metalldrahtgitters gewählt. Die Schraube kann damit zum einen gegen das Gitter angezogen und zugleich in seinen Maschen gehalten werden.

Grundsätzlich kann für eine jeweilige Schraube eine Unterlegscheibe vorgesehen sein, deren Durchmesser grosser als die Maschenweite des ersten bzw. zweiten Metalldrahtgitters ist. Dadurch kann ein und dieselbe Schraube in Metalldrahtgittern unterschiedlich grosser Maschenweite Verwen-dung finden, wenn nur die Unterlegscheibe entsprechend angepasst wird.

Um auszuschliessen, dass die Schrauben- und Widerlagerkombination als Wärme- oder Kältebrücke wirkt, kann die Schraube grundsätzlich aus einem nur schlecht wärmeleitfähigen Material hergestellt sein. Um aber auch besonders hochbelastbare Schrauben aus einem Metallmaterial einsetzen zu können, ist der Kopf einer jeweiligen Schraube bevorzugt mit einer Kunststoffkappe abdeckbar und/oder die Unterlegscheibe besteht aus einem Kunststoff. Damit ist der Schraubenkopf gegenüber seiner unmittelbaren Umgebung vollständig verkapselt und somit wärmeisoliert.

Grundsätzlich kann das Stützelement auch selbst aus einem Holz- oder Kunststoffmaterial ausgeführt sein, womit eine darin eingedrehte - selbstschneidende - Schraube auch auf Seiten ihres Widerlagers Wärmeisoliert wäre. Besteht das Stützelement aber aus einem metallischen Werkstoff ist es bevorzugt, wenn eine jeweilige Stützelement- und Widerlagerkombination so geformt und bemessen sein, dass eine in das Widerlager eingedrehte Schraube nicht mit dem Stützelement in Kontakt tritt.

Eine besonders einfache Montage der Stützelement- und Widerlagerkombination ist dabei dann gegeben, wenn diese so geformt und bemessen ist, dass beim Eindrehen der Schraube eine Bewegung des Widerlagers gegenüber dem Stützelement blockiert ist. Das Widerlager wird somit passgenau von dem Stützelement aufgenommen, was weitere Verbindungselemente oder -Materialien zwischen beiden überflüssig macht.

Bevorzugt weist dazu ein jeweiliges Stützelement eine im Wesentlichen U-förmige Querschnittsform auf, deren Schenkel mit Durchtrittsöffnungen zur Aufnahme der Befestigungselemente versehen sind. Ein derart geformtes Stützelement hat den Vorteil, dass dessen Basis als Anschlag für ein entsprechend geformtes Widerlager dienen kann.

Unabhängig von der Form der Stützelemente können diese bevorzugt genutzt werden, um in der Wandstruktur elektrische Leitungen unterzubringen, die in der Isolationsschicht verlaufen und von den Stützelementen gehalten sind.

In einer weiteren bevorzugten Ausführungsform ist die erfindungsgemässe Wandstruktur mit Heiz- und/oder Kühlschläuchen versehen, die in der Innen- und/oder Aussenverkleidung verlegt sind und im Wesentlichen zwischen den Wellenbergen des ersten und/oder zweiten Metalldrahtgitters verlaufen, welche über die jeweilige Oberfläche des ersten und/oder zweiten Stützkörpers hinausragen. Dadurch werden die Schläuche einerseits zwischen den Wellenbergen geführt und können einfach verlegt werden. Gleichzeitig können die Schläuche auch leicht an dem ersten bzw. zweiten Gitter befestigt werden, z.B. mittels an sich bekannten Kabelbindern.

Eine noch einfachere Befestigung entsteht dann, wenn die Heiz- und/oder Kühlschläuche zwischen einem jeweils zusätzlichen, sich über die Wellenberge der ersten und/oder zweiten Metalldrahtgitter hinweg erstreckenden, ebenen Metalldrahtgitter und dem ersten und/oder zweiten wellenförmigen Metalldrahtgitter gehalten sind. Damit werden die Schläuche flächig abgedeckt und zwischen den Wellenbergen des ersten bzw. zweiten Gitters fixiert, was einfacher zu bewerkstelligen ist.

Alternativ dazu können die Heiz- und/oder Kühlschläuche auch in einem jeweils zusätzlichen dreidimensionalen Metalldrahtgitter gehalten sein, das sich über die Wellenberge der ersten und/oder zweiten Metalldrahtgitter hinweg erstreckt. Sowohl das erste bzw. zweite als auch das zusätzliche Gitter werden z.B. in einer Putz- oder Mörtelschicht aufgenommen, die dadurch an Stabilität bzw. Tragfähigkeit gewinnt. Die Schläuche können dabei schon in dem zusätzlichen Gitter verlegt sein, bevor dieses Gitter angebracht wird.

Dadurch wird die Montage der Heiz- und/oder Kühlschläuche deutlich erleichtert und beschleunigt.

Eine besonders gute Tragfähigkeit, Dämm- und Strahlungsschutzwirkung des ersten und zweiten Metalldrahtgitters wird erzielt, wenn deren Maschenweite zwischen 5 mm und 30 mm liegt, bevorzugt ungefähr 10 mm beträgt.

In bevorzugter Weise sollen vorgefertigte Bauelemente für ein Gebäude, insbesondere Wand-, Boden- oder Deckenelemente, die erfindungsgemässe Wandstruktur aufweisen. Diese Elemente können entsprechend der vorstehend beschriebenen Ausführungsformen konfiguriert werden, so dass sich weitere Montagevorgange "On site" erübrigen. Damit ist eine besonders schnelle Erstellung von Gebäuden in unterschiedlichen, dem Kundenwunsch gemässen Varianten möglich.

Gebäude mit diesen vorgefertigten Bauelementen werden bevorzugt so gestaltet, dass die Bauelemente so angeordnet und miteinander verbunden sind, dass deren erste und/oder zweite Metalldrahtgitter einen Faradayschen Käfig bilden. Damit ist ein idealer Strahlungsschutz gegenüber dem Gebäudeäusseren, z.B. gegen Telekommunikationsstrahlung, Hochspannungsfelder, radioaktive Strahlung o. A. sichergestellt.

Ausführungsbeispiele der Erfindung werden im Folgenden unter Bezugnahme auf die beigelegten Figuren detailliert erläutert. Massangaben in den Zeichnungen stellen Angaben in Millimetern [mm] dar. Gleiche oder gleichwirkende Teile sind mit gleichen Bezugsziffern versehen. Es zeigen:
- Figur 1: eine Querschnittsansicht einer ersten erfindungsgemässen Wandstruktur zur Verdeutlichung ihres grundlegenden Aufbaus;
- Figur 2A: eine Querschnittsansicht einer zweiten erfindungsgemässen Wandstruktur mit Innenverkleidung;
- Figur 2B: eine räumliche Darstellung der Wandstruktur der Figur 2A;
- Figur 3A: eine Querschnittsansicht einer dritten erfindungsgemässen Wandstruktur mit Innenverkleidung;
- Figur 3B: eine räumliche Darstellung der Wandstruktur der Figur 3A; Figur 4A eine räumliche Darstellung eines zusätzlichen dreidimensionalen Metalldrahtgitters zur Aufnahme von Heiz- und/oder Kühlschläuchen;
- Figur 4B: eine räumliche Darstellung eines ersten bzw. zweiten wellenförmigen Metalldrahtgitters zur Einbettung in erste bzw. zweite Stützkörper;
- Figur 5A: eine Seitenansicht eines ersten bzw. zweiten Stützkörpers mit den Gittern der Figuren 4;
- Figur 5B: eine Vorderansicht des ersten bzw. zweiten Stützkörpers nach Figur 5A, und
- Figur 6: eine Draufsicht auf die Gitter der Figuren 5.

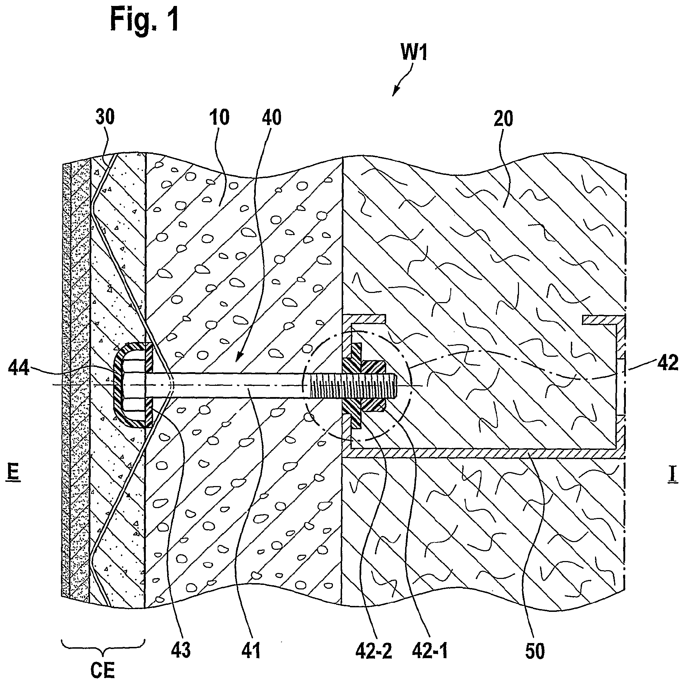

Die Figur 1 zeigt eine Querschnittsansicht einer ersten erfindungsgemässen Wandstruktur W1 (Wall 1) zur Verdeutlichung ihres grundlegenden Aufbaus. Eine Grundstruktur umfasst dabei einen ersten Stützkörper 10 aus einem Polyurethan-Schaum mit einer Kieseinlage, an dessen zum Gebäudeinneren I (Interior) gerichteten Oberfläche eine Isolationsschicht 20 aus Mineralwolle anliegt. Ein erstes wellenförmiges Metalldrahtgitter 30 ist in die zum Gebäudeäusseren E (Exterior) gerichteten Oberfläche des ersten Stützkörpers 10 eingeschäumt , so dass dessen Wellenberge davon abstehen. Erster Stützkörper 10 und erstes wellenförmiges Gitter 30 stellen tragende Elemente der Struktur W1 dar. Durch den Stützkörper 10 hindurch erstrecken sich Befestigungselemente 40, die im Wesentlichen U-förmige Stützelemente 50 aus einem Stahl halten, zwischen denen die Isolationsschicht 20 aufgenommen und damit am Stützkörper 10 gehalten ist. Beispielhaft ist hier ein Befestigungselement 40 gezeigt, das aus einer (Schaft) Schrauben- und Widerlagerkombination 41, 42 besteht.

Das Widerlager 42 umfasst dabei eine Mutter 42-1, die gegen eine Kunststoffbuchse 42-2 angezogen wird, welche wiederum formschlüssig in dem U-förmigen Stützelement 50 aufgenommen ist. Damit wird eine Isolation des Befestigungselements 40 erzielt, die einen Wärmeübergang zwischen Stützelement 50 und Schraube 41 (oder umgekehrt) verhindert. Um die Isolationswirkung der Schrauben- und Widerlagerkombination 41, 42 noch zu erhöhen, besteht die Schraube 41 zusätzlich aus einem schlecht wärmeleitenden, aber dennoch ausreichend zugfesten Kunststoffmaterial. Zum Gebäudeäusseren ist deren Schraubenkopf zudem mit einer Abdeckung 44 und einer Unterlegscheibe 43 aus Kunststoff versehen, um auch dort den isolierenden Effekt zu erhalten. Die Unterlegscheibe 43 weist dabei einen Durchmesser auf, der grosser als die Maschenweite des ersten Gitters 30 ist, so dass das Gitter der Anzugskraft der Schraube 41 entgegen wirkt und diese gleichzeitig in Position halt. Die zum Gebäudeäusseren gerichtete Oberfläche des ersten Stützkörpers 10 ist mit einer Aussenverkleidung CE (Cover Exterior) versehen, die unterschiedliche Schichten Mörtel und eine Verklinkerung (nicht naher bezeichnet) umfasst.

Das erste wellenförmige Metalldrahtgitter 30 greift dabei in die Aussenverkleidung CE ein und halt diese, so dass deren Tragfähigkeit erheblich erhöht wird. Gleichzeitig dient es zur Verstärkung des Stützkörpers 10 und zur flächigen Spannungsverteilung in diesem Körper 10. Dies führt zum einen zu einer deutlich erhöhten Tragfähigkeit der Wandstruktur W1 und verhindert zum anderen eine Rissbildung in Stützkörper 10 und Aussenverkleidung CE. Dadurch ist die Wandstruktur W1 gegen statische wie auch dynamische Beanspruchung, und zwar sowohl in vertikaler wie auch horizontaler Richtung besonders resistent. Das erste Gitter 30 wirkt zudem als Wärmedämmung, da es Wärme ableitet und so eine Aufheizung der Struktur W1 verhindert. Ausserdem stellt es einen wirksamen Schutz gegen alle Arten von elektromagnetischen Feldern dar. Der konstruktive Ausschluss einer Wärmebrücke am Befestigungselement 40 in Verbindung mit dem ersten Stützkörper 10 aus Schaumstoff und der Isolationsschicht 20 aus Mineralwolle sorgt weiterhin für eine optimale Wärme- und Schalldämmung der Struktur W1. Der Stützkörper 10 kann noch mit einem vollständig darin eingeschäumten, zusätzlichen dreidimensionalen Metalldrahtgitter versehen sein, dass dessen Belastungsfähigkeit noch weiter erhöht.

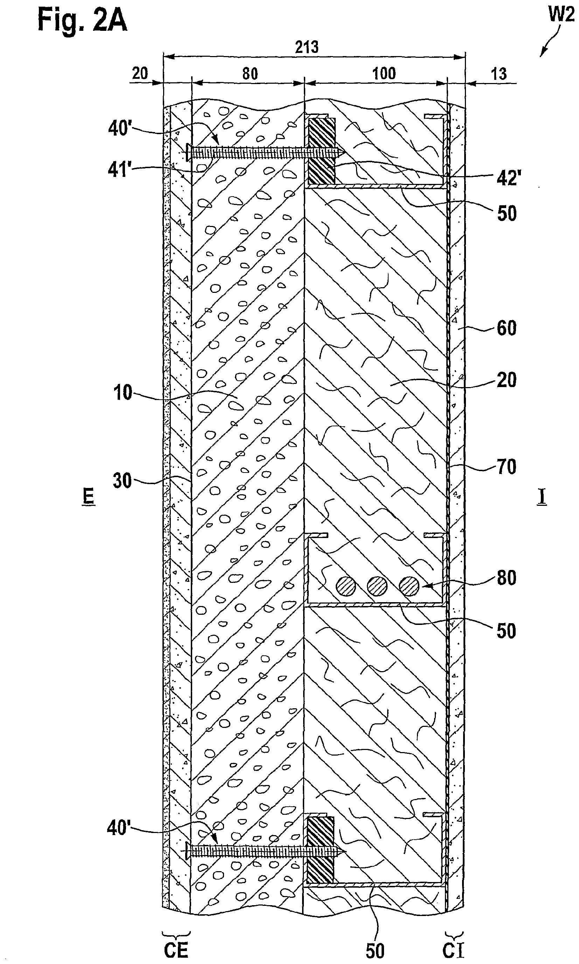

Die Figur 2A zeigt eine Querschnittsansicht einer zweiten erfindungsgemässen Wandstruktur W2 mit Innenverkleidung CI (Cover Interior), die vom Grundaufbau der bereits in Figur 1 gezeigten Wandstruktur W1 ausgeht. Die Innenverkleidung CI besteht beispielhaft aus Gipskartonplatten 60, welche die Isolationsschicht 20 vollständig abdecken und über hier nicht gezeigte Befestigungselemente mit den U-förmigen Stützelementen 50 verbunden sind. Die Stützelemente 50 dienen damit der Aufnahme der Isolationsschicht 20 und der Halterung der Innenverkleidung 60. Im Unterschied zur Wandstruktur W1 der Figur 1 werden die Stützelemente 50 von Befestigungselementen 40' gehalten, die aus einer Schrauben- und Widerlagerkombination 41', 42' bestehen. Die Schraube 41' ist dabei mit einem selbstschneidenden Gewinde ausgestattet, welches in das Widerlager 42' aus einem Kunststoff- oder auch Holzmaterial eingedreht wird. Das Widerlager 42' ist formschlüssig und damit gegen Verdrehung blockiert in einem Schenkel des U-förmigen Stützelements 50 aufgenommen, der dazu das Widerlager 42' an seiner Oberseite noch einmal umgreift. Insgesamt lasst eine solche Ausführung der Befestigungselemente 40' die besonders einfache und vollautomatisierbare Montage der Wandstruktur W2 zu. Zwischen Innenverkleidung CI und Isolationsschicht 20 ist dabei eine dampfdurchlässige Folie 70 aus einem PVC-Material angebracht, um eine Belüftung der innenliegenden Isolationsschicht 20 bei gleichzeitiger Verhinderung eines Flüssigkeitsdurchtritts zu gewährleisten. Da sich die Innenverkleidung CI bereits vormontieren lasst, ist deren Anbringung "On site" nicht mehr erforderlich. Kundenwunsche können zudem bereits in einer sehr frühen Gebäudeerstellungsphase Berücksichtigung finden. Die Aussenverkleidung CE der hier gezeigten Wandstruktur W2 soll prinzipiell nicht anders sein als diejenige der Figur 1. Insgesamt ist die Struktur W2 damit besonders belastbar, ohne die anderen in Bezug auf Figur 1 schon geschilderten Vorteile vermissen zu lassen. In der Wandstruktur W2 sind darüber hinaus noch elektrische Leitungen 80 verlegt, die in der Isolationsschicht 20 verlaufen und in den U-förmigen Stützelementen 50 gehalten werden. Damit ist auch eine elektrische Verkabelung in der Wandstruktur vorkonfektionierbar, die On site' lediglich noch verschaltet werden muss.

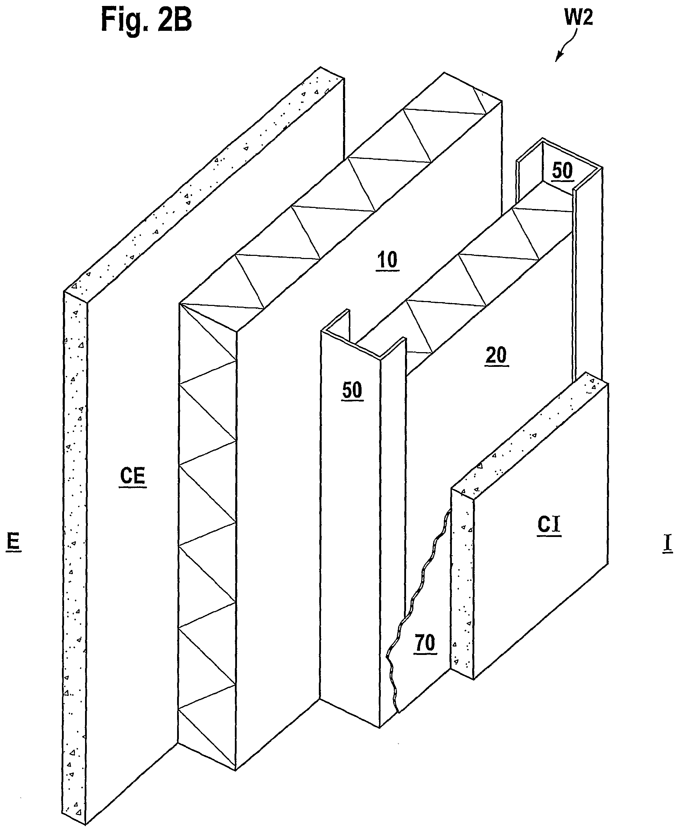

Die Figur 2B zeigt eine räumliche Darstellung der Wandstruktur der Figur 2A. Zwischen der Innen- und Aussenverkleidung CI und CE der Struktur W2 ist der erste Stützkörper 10 zu erkennen, an den die Isolationsschicht 20 angrenzt. Die räumliche Ausführung der Stützelemente 50 zeigt, dass diese als langgestreckte U-förmige Bleche ausgeführt sind. Die Öffnungen der Stützelemente 50 sind im dargestellten Abschnitt der Struktur W2 einander so zugewandt, dass die Isolationsschicht 20 zwischen diesen gehalten wird. Zwischen der Innenverkleidung CI und der Isolationsschicht 20 erstreckt sich eine PVC-Folie 70, die durchlässig für Gase und Wasserdampfe ist und dem Wasserdurchgang in Flüssigkeitsform widersteht. Aus Übersichtlichkeitsgründen sind die Befestigungselemente 40 und das in dem ersten Stützkörper 10 eingebettete erste wellenförmige Metalldrahtgitter 30 nicht dargestellt. Die räumliche Darstellung der Struktur W2 verdeutlicht den einfachen und kompakten Aufbau der erfindungsgemässen Gebäudewand, der extrem tragfähig und robust und gleichzeitig strahlungsundurchlässig sowie Wärme- und schalldämmend ist. Eine entsprechende Wand kann zudem wunschgemäss konfiguriert, vollautomatisiert hergestellt und "On site" verbaut werden.

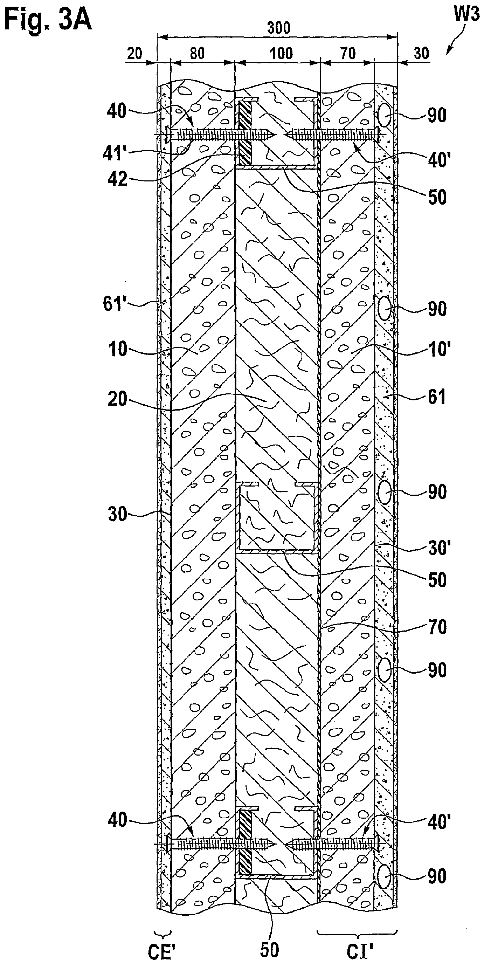

Die Figur 3A zeigt eine Querschnittsansicht einer dritten erfindungsgemässen Wandstruktur W3 mit Innenverkleidung CI ' . Die Struktur W3 geht dabei von dem schon in Figur 2 beschriebenen Grundaufbau der Wandstruktur W2 aus. Die Stützelemente 50 werden auch hier über Befestigungselemente 40 gehalten, die eine selbstschneidende Schraube 41' umfassen, die in ein Widerlager 42' aus einem Kunststoff- oder auch Holzmaterial eingedreht wird. Die Aussenverkleidung CE' der Struktur W3 weist hier eine Aussenputzschicht 61' auf, die an dem ersten wellenförmigen Metalldrahtgitter 30 verankert ist. Die Struktur W3 unterschiedet sich weiterhin durch ihre Innenverkleidung CI ' , die einen zweiten Stützkörper 10 'und eine Innenputzschicht 61' umfasst, in der Heiz- und/oder Kühlschläuche 90 zum Heizen bzw. Kuhlen des Gebäudeinneren I verlegt sind. Der zweite Stützkörper 10' ist spiegelbildlich zum ersten Stützkörper 10 mit einem zweiten wellenförmigen Metalldrahtgitter 30' ausgestattet, das ebenfalls wenigstens teilweise in diesen eingebettet ist. Ebenfalls spiegelbildlich zum ersten Stützkörper 10 wird der zweite Stützkörper 10' über Befestigungselemente 40' mit selbstschneidenden Schrauben an den Stützelementen 50 befestigt. Das zweite wellenförmige Gitter 30' erfüllt dabei wie beim ersten Stützkörper 10 zum einen die Aufgabe, die Befestigungselemente 40' zu stabilisieren, d.h. zu Stützen und in Position zu halten. Zum anderen aber dient es hier zusätzlich der Führung und Befestigung der Heiz- und/oder Kühlschläuche 90 zwischen den Wellenbergen des abstehenden Gitters 30'. Damit ist eine besonders einfache Verlegung und Befestigung dieser Schläuche 90 am zweiten Stützkörper möglich, bevor der Innenputz 61 aufgebracht wird. Grundsätzlich ist es natürlich zusätzlich oder alternativ möglich, in an sich ähnlicher Art und Weise Heiz- und/oder Kühlschläuche im Aussenputz 61' anzubringen. Zwischen Innenverkleidung CI' und Isolationsschicht 20 ist wiederum eine dampfdurch-lässige Folie 70 angebracht. In der Isolationsschicht 20 können natürlich auch hier elektrische Leitungen verlegt sein, was hier aus Übersicht-lichkeitsgründen aber nicht dargestellt ist. Auf Grund der Innenverkleidung CI' mit zweitem Stützkörper 10' weist die dargestellte Wandstruktur W3 eine gesteigerte Tragfähigkeit und Stabilität auf, die aber grundsätzlich auch noch durch Einschäumen von dreidimensionalen Metalldrahtgittern in die Stützkörper 10, 10' erhöht werden konnte. Gleichzeitig wird die Wärme- und Schalldämmung der Struktur W3 erhöht, und durch die Dopplung der wellenförmigen Gitter 30, 30' ein erhöhter Strahlungsschutz erreicht.

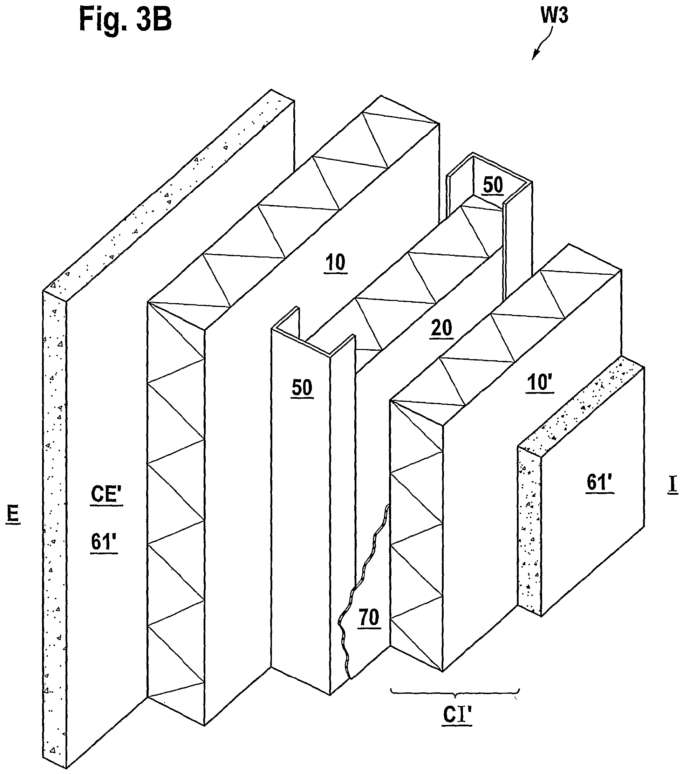

Die Figur 3B zeigt eine räumliche Darstellung der Wandstruktur W3 der Figur 3A. Aus dieser ist noch einmal der Grundaufbau der erfindungsgemässen Struktur ersichtlich, der zwischen der Aussen- und Innenverkleidung CE', CI' aufgenommen ist. Die Innenverkleidung CI' umfasst dabei den zweiten Stützkörper 10' und eine Innenputzschicht 61. Zwischen Innenverkleidung CI' und Isolationsschicht 20 ist die dampfdurchlässige Folie 70 angebracht. Auch die räumliche Darstellung der Struktur W3 verdeutlicht den einfachen und kompakten Aufbau einer erfindungsgemässen Gebäudewand, der extrem tragfähig und robust, gleichzeitig strahlungsundurchlässig sowie Wärme- und schalldämmend ist. Eine diese Wand kann wunschgemäss konfiguriert, vollautomatisiert hergestellt und "On site" verbaut werden.

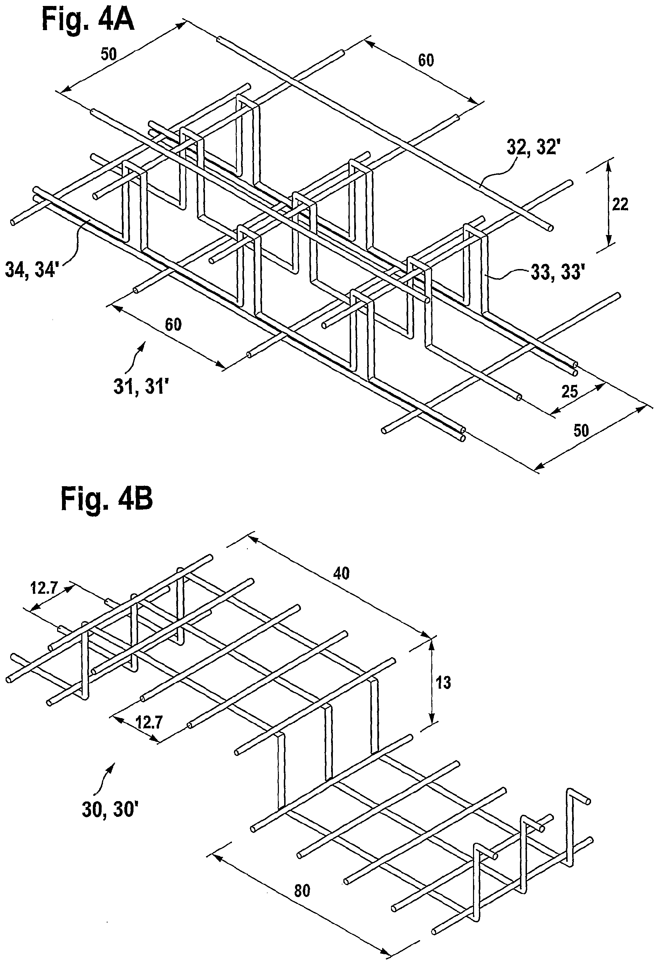

Die Figur 4A zeigt eine räumliche Darstellung eines zusätzlichen dreidimensionalen Metalldrahtgitters 31, 31' zur Aufnahme von Heiz- und/oder Kühlschläuchen 90. Das Gitter 31, 31' besteht aus zwei ebenen Gittern 32, 32' und 34, 34', zwischen denen ein dreidimensionales wellenförmiges Gitter 33, 33 ' angebracht ist. Die dadurch entstehende, äusserst stabile Konstruktion kann in eine Innen- und/oder Aussenverkleidung CI', CE' der erfindungsgemässen Wandstruktur eingebettet werden und zu deren zusätzlicher Stabilisierung dienen. Insbesondere können aber auch Heiz- und/oder Kühlschläuche in den Kanälen der Gitter 31, 31' aufgenommen sein, und zwar schon vor Anbringung des Gitters 31, 31' in den Verkleidungen CI', CE'. Damit wird eine besonders einfache Verlegung der Schläuche möglich.

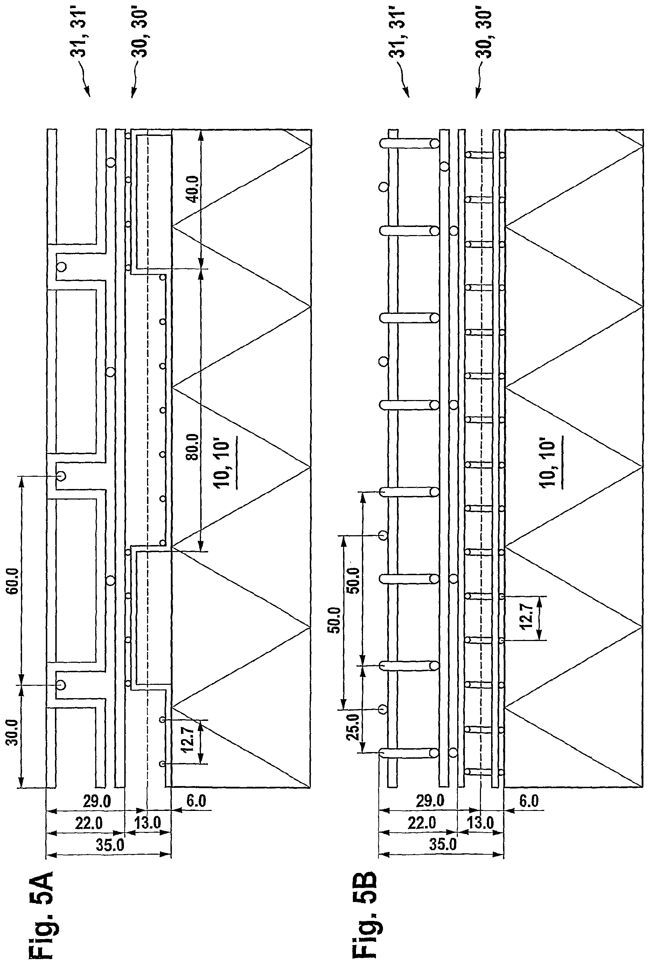

Die Figur 4B zeigt eine räumliche Darstellung eines ersten bzw. zweiten wellenförmigen Metalldrahtgitters 30, 30' zur Einbettung in erste bzw. zweite Stützkörper 10, 10'. Das Wellental der Gitter 30, 30' ist dabei in die Oberfläche der Stützkörper 10, 10' eingeschäumt, wahrend die Wellenberge davon abstehen und eine aufzubringende Putz- oder Mörtelschicht eingreifen. Die Maschenweite der Gitter beträgt hier 12, 7 mm. Die Figur 5A zeigt eine Seitenansicht eines ersten bzw. zweiten Stützkörpers 10, 10' mit den Gittern 30, 30' und 31, 31' der Figuren 4. Die Gitter 30, 30' werden in einer Tiefe von 6 mm in die Stützkörper 10, 10' eingeschäumt und an ihrer Oberseite mit dem dreidimensionalen Gitter 31, 31' verbunden. In den Kanälen des Gitters 31, 31' können Heiz- und/oder Kühlschläuche verlegt sein, bevor die Gitter 31, 31' in eine Verkleidung eingebettet werden. Bei entsprechender Bemessung der Gitter 30, 30' ist aber auch eine Verlegung der Schläuche zwischen den Wellenbergen der Gitter 30, 30' und deren Halterung durch die Gitter 31, 31' denkbar, welche über die Wellenberge hinweg geführt sind.

Die Figur 5B zeigt eine Vorderansicht des ersten bzw. zweiten Stützkörpers 10, 10' der Figur 5A. Dabei wird ersichtlich, dass die Heiz- und/oder Kühlschläuche auch in einer senkrecht zu den Kanälen der Figur 5A verlaufenden Richtung verlegbar sind, so dass sich eine durchgängig gute Halterung der Schläuche in allen Richtungen ergibt.

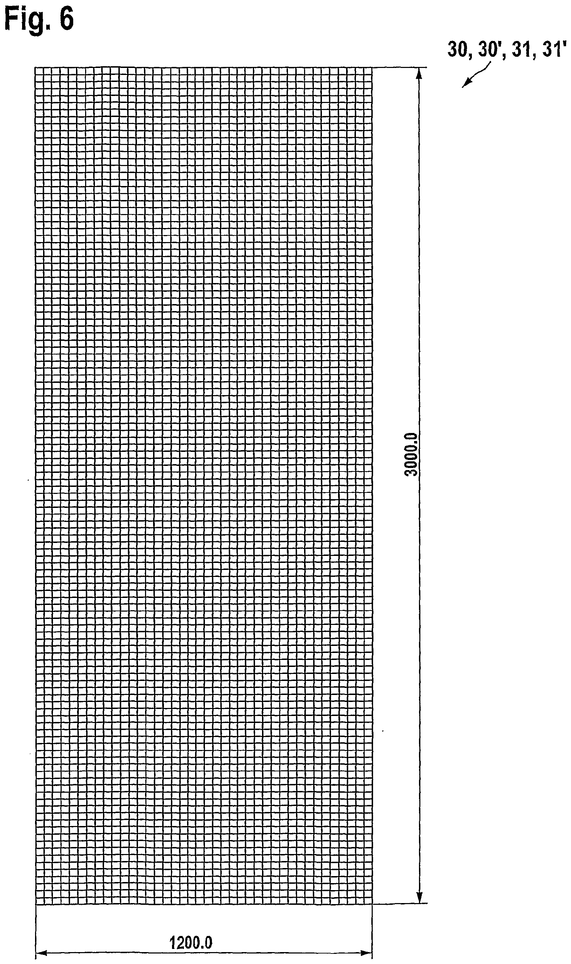

Die Figur 6 zeigt eine Draufsicht auf die Gitter 30, 30<'> und 31, 31' der Figuren 5, aus der sich die durchgängig gleiche Maschenweite der gemeinsamen Gitterstruktur ergibt. Diese erfordert nur ein durchgängig gleiches Befestigungselement, welches die Gitter 30, 30' (oder zusätzlich die Gitter 31, 31') und die Stützkörper 10, 10' durchtritt, um die Stützelemente am Stützkörper 10, 10' zu befestigen. Die Figur veranschaulicht auch, dass eine solche Gitterstruktur besonders gut geeignet ist, in gleichem Mass stabilisierend und Wärmeableitend zu wirken sowie unerwünschte elektromagnetische Strahlung zu blockieren. Insbesondere lassen sich Wandelemente mit der erfindungsgemässen Struktur so miteinander verbinden, dass ein Faradayscher Käfig entsteht, der ein Gebäudeinneres vor Strahlung, Blitzschlag o. Ä. schützt.

Grundsätzlich ist natürlich denkbar, zur weiteren Verbesserung der Leistungsfähigkeit der erfindungsgemässen Wandstruktur eine mehrfache Schichtung ihres Grundaufbaus, also eine mehrfache Aneinanderreihung von Stützkörpern mit Metalldrahtgittern sowie Isolierungsschichten vorzunehmen, die jeweils über Befestigungselemente miteinander verbunden sind. Entsprechende Schichtungen sind abhängig von den spezifischen Anforderungen an eine Wandstruktur für Gebäude und liegen im Ermessen des Fachmanns.

## Patentansprüche

1. Vorgefertigtes Wandelement (W1; W2; W3) für ein Gebäude, mit einem ersten plattenförmigen Stützkörper (10) aus einem massiven Schaummaterial, dessen zum Gebäudeinneren (I) auszurichtende Oberfläche an eine Isolationsschicht (20) angrenzt, und mit ersten Befestigungselementen (40), die den ersten plattenförmigen Stützkörper (10) durchgreifen, um Stützelemente (50) zu befestigen, zwischen denen die Isolationsschicht (20) aufgenommen ist, **dadurch gekennzeichnet, dass** das Bauelement weiter ein erstes wellenförmig ausgebildetes Metalldrahtgitter (30) umfasst, das wenigstens teilweise in eine zum Gebäudeäusseren (E) auszurichtenden Oberfläche des ersten Stützkörpers (10) eingebettet ist, wobei die Maschenweite des ersten wellenförmig ausgebildeten Metalldrahtgitters (30) zwischen 5 mm und 30 mm liegt, bevorzugt ungefähr 10 mm beträgt, wobei die ersten Befestigungselemente das erste wellenförmig ausgebildete Metalldrahtgitter (30) durchgreifen, und wobei das vorgefertigte Wandelement weiter ein zusätzliches dreidimensionalen Metalldrahtgitter (31) zur Aufnahme von Heiz- und/oder Kühlschläuche (90) umfasst, das sich über die Wellenberge des ersten wellenförmig ausgebildeten Metalldrahtgitters (30) hinweg erstreckt.

2. Vorgefertigtes Wandelement nach Anspruch 1, mit einer Innenverkleidung (CI), welche an eine zum Gebäudeinneren (I) auszurichtende Oberfläche der Isolationsschicht (20) angrenzt, und mit zweiten Befestigungselementen (40'), welche die Innenverkleidung (CI) durchgreifen, um diese an den Stützelementen (50) zu befestigen, wobei die Innenverkleidung (CI) vorzugsweise Gipskartonplatten (60) umfasst.

3. Vorgefertigtes Wandelement nach Anspruch 2, bei der die Innenverkleidung (CI) einen zweiten plattenförmigen Stützkörper (10') aus einem massiven Schaummaterial umfasst, der angrenzend zu der Isolationsschicht (20) angeordnet ist, wobei die Innenverkleidung (CI) ein zweites wellenförmig ausgebildetes Metalldrahtgitter (30') umfasst, das wenigstens teilweise in eine zum Gebäudeinneren (I) auszurichtende Oberfläche des zweiten Stützkörpers (10') eingebettet ist, wobei die Maschenweite des zweiten wellenförmig ausgebildeten Metalldrahtgitters (30') zwischen 5 mm und 30 mm liegt, bevorzugt ungefähr 10 mm beträgt.

4. Vorgefertigtes Wandelement nach einem der vorstehenden Ansprüche, **dadurch gekennzeichnet, dass** erste und/oder zweite wellenförmig ausgebildete Metalldrahtgitter (30, 30') wenigstens teilweise in den ersten und/oder zweiten Stützkörper (10, 10') eingeschäumt ist.

5. Vorgefertigtes Wandelement nach einem der vorstehenden Ansprüche, mit einer Aussenverkleidung (CE), die an eine zum Gebäudeäusseren (E) auszurichtende Oberfläche der ersten Stützschicht (10) angrenzt, wobei die Aussenverkleidung Zierplatten oder eine Verklinkerung umfasst.

6. Vorgefertigtes Wandelement nach einem der vorstehenden Ansprüche, mit einem jeweils zusätzlichen dreidimensionalen Metalldrahtgitter (31'), das sich über die Wellenberge des zweiten wellenförmig ausgebildeten Metalldrahtgitters (30') hinweg erstreckt und in welchem Heiz- und/oder Kühlschläuche (90) haltbar sind.

7. Vorgefertigtes Wandelement nach einem der vorstehenden Ansprüche, bei dem die ersten und/oder zweiten Befestigungselemente (40, 40') aus einer jeweiligen Schrauben und Widerlagerkombination (41, 42) bestehen.

8. Vorgefertigtes Wandelement nach Anspruch 7, bei welchem der Kopf einer jeweiligen Schraube (41) mit einer Kunststoffkappe (44) abdeckbar ist und/oder eine Unterlegscheibe (43) aus einem Kunststoff aufweist.

9. Vorgefertigtes Wandelement nach einem der Ansprüche 7 bis 8, bei dem eine jeweilige Stützelement und Widerlagerkombination (50, 42) so geformt und bemessen ist, dass eine in das Widerlager (42) eingedrehte Schraube (41) nicht mit dem Stützelement (50) in Kontakt tritt.

10. Vorgefertigtes Wandelement nach einem der vorstehenden Ansprüche, mit Heiz- und/oder Kühlschläuchen (90), die in der Innen- und/oder Aussenverkleidung (CI, CE) verlegt sind.

11. Vorgefertigtes Wandelement nach Anspruch 10, bei dem die Heiz- und/oder Kühlschläuche (90) im Wesentlichen zwischen den Wellenbergen des ersten und/oder zweiten wellenförmig ausgebildeten Metalldrahtgitters (30, 30') verlaufen, welche über die jeweilige Oberfläche des ersten und/oder zweiten Stützkörpers (10, 10') hinausragen.

12. Vorgefertigtes Wandelement nach Anspruch 10, bei dem die Heiz- und/oder Kühlschläuche (90) in dem jeweils zusätzlichen dreidimensionalen Metalldrahtgitter (31, 31') gehalten sind, das sich über die Wellenberge der ersten und/oder zweiten Metalldrahtgitter (30, 30') hinweg erstreckt.

13. Gebäude mit vorgefertigten Wandelement nach einem der vorstehenden Ansprüche, die so angeordnet und miteinander verbunden sind, dass deren erste und/oder zweite Metalldrahtgitter (30, 30') einen Faradayschen Käfig bilden.

## Claims

1. A prefabricated wall element (W1; W2; W3) for a building, having a first planar supporting body (10) consisting of a solid foam material, the surface of which that is to face the building interior (I) borders an insulation layer (20), and having first fastening elements (40), which pass through the first planar supporting body (10) in order to fasten supporting elements (50), between which the insulation layer (20) is held, **characterised in that** the structural element further comprises a first corrugated metal wire grid (30), which is embedded at least partially in a surface of the first supporting body (10), which surface is to face the building exterior (E), wherein the mesh size of the first corrugated metal wire grid (30) is between 5 mm and 30 mm, preferably approximately 10 mm, wherein the first fastening elements pass through the first corrugated metal wire grid (30), and wherein the prefabricated wall element further comprises an additional three-dimensional metal wire grid (31) for accommodating heating and/or cooling pipes (90), said grid extending beyond the peaks of the first corrugated metal wire grid (30).

2. The prefabricated wall element according to claim 1, having inner cladding (CI), which borders a surface of the insulation layer (20), which surface is to face the building interior (I), and having second fastening elements (40'), which pass through the inner cladding (CI) in order to fasten same to the supporting elements (50), wherein the inner cladding (CI) preferably comprises plasterboards (60).

3. The prefabricated wall element according to claim 2, in which the inner cladding (CI) comprises a second planar supporting body (10'), which consists of a solid foam material and is arranged adjacently to the insulation layer (20), wherein the inner cladding (CI) comprises a second corrugated metal wire grid (30'), which is embedded at least partially in a surface of the second supporting body (10'), which surface is to face the building interior (I), wherein the mesh size of the second corrugated metal wire grid (30') is between 5 mm and 30 mm, preferably approximately 10 mm.

4. The prefabricated wall element according to any one of the preceding claims, **characterised in that** the first and/or second corrugated metal wire grid (30, 30') is foamed at least partially into the first and/or second supporting body (10, 10').

5. The prefabricated wall element according to any one of the preceding claims, having outer cladding (CE), which borders a surface of the first supporting layer (10), which surface is to face the building exterior (E), wherein the outer cladding comprises decorative panels or brick facing.

6. The prefabricated wall element according to any one of the preceding claims, having an additional three-dimensional metal wire grid (31'), which extends beyond the peaks of the second corrugated metal wire grid (30') and in which heating or cooling pipes (90) can be held.

7. The prefabricated wall element according to any one of the preceding claims, in which the first and/or second fastening elements (40, 40') consist of a bolt and counter bearing combination (41, 42) in each case.

8. The prefabricated wall element according to claim 7, in which the head of each bolt (41) can be covered with a plastic cap (44) and/or has a washer (43) consisting of a plastic.

9. The prefabricated wall element according to either of claims 7 or 8, in which each supporting element and counter bearing combination (50, 42) is shaped and sized such that a bolt (41) screwed into the counter bearing (42) does not come into contact with the supporting element (50).

10. The prefabricated wall element according to any one of the preceding claims, having heating and/or cooling pipes (90), which are laid in the inner and/or outer cladding (CI, CE).

11. The prefabricated wall element according to claim 10, in which the heating and/or cooling pipes (90) run substantially between the peaks of the first and/or second corrugated metal wire grid (30, 30'), which project beyond the respective surface of the first and/or second supporting body (10, 10').

12. The prefabricated wall element according to claim 10, in which the heating and/or cooling pipes (90) are held in the respective additional three-dimensional metal wire grid (31, 31'), which extends beyond the peaks of the first and/or second metal wire grid (30, 30').

13. A building having a prefabricated wall element according to any one of the preceding claims, which are arranged and connected to each other such that the first and/or second metal wire grids (30, 30') thereof form a Faraday cage.

## Revendications

1. Elément mural préfabriqué (W1 ; W2 ; W3) pour un bâtiment, avec un premier corps de support en forme de plaque (10) en une matière en mousse massive dont la surface à orienter vers l'intérieur du bâtiment (I) jouxte une couche d'isolation (20), et avec des premiers éléments de fixation (40) qui traversent le premier corps de support en forme de plaque (10) pour fixer des éléments de support (50) entre lesquels la couche d'isolation (20) est réceptionnée, **caractérisé en ce que** l'élément de construction comprend en outre un premier grillage en fil métallique réalisé avec une forme ondulée (30), lequel est au moins partiellement incorporé dans une surface, à orienter vers l'extérieur du bâtiment (E), du premier corps de support (10), dans lequel l'ouverture de maille du premier grillage en fil métallique réalisé avec une forme ondulée (30) est comprise entre 5 mm et 30 mm, en étant de préférence de 10 mm environ, dans lequel les premiers éléments de fixation traversent le premier grillage en fil métallique réalisé avec une forme ondulée (30), et dans lequel l'élément mural préfabriqué comprend en outre un grillage en fil métallique tridimensionnel (31) supplémentaire pour la réception de flexibles de chauffage et/ou de refroidissement (90), lequel s'étend par-delà les sommets d'ondulation du premier grillage en fil métallique réalisé avec une forme ondulée (30).

2. Elément mural préfabriqué selon la revendication 1, avec un revêtement intérieur (CI) qui jouxte une surface, à orienter vers l'intérieur du bâtiment (I), de la couche d'isolation (20), et avec des deuxièmes éléments de fixation (40') qui traversent le revêtement intérieur (CI) pour fixer celui-ci aux éléments de support (50), dans lequel le revêtement intérieur (CI) comprend de préférence des plaques de plâtre (60).

3. Elément mural préfabriqué selon la revendication 2, dans lequel le revêtement intérieur (CI) comprend un deuxième corps de support en forme de plaque (10') en une matière en mousse massive qui est disposée de manière à jouxter la couche d'isolation (20), dans lequel le revêtement intérieur (CI) comprend un deuxième grillage en fil métallique réalisé avec une forme ondulée (30') qui est au moins partiellement incorporé dans une surface, à orienter vers l'intérieur du bâtiment (I), du deuxième corps de support (10'), dans lequel l'ouverture de maille du deuxième grillage en fil métallique réalisé avec une forme ondulée (30') est comprise entre 5 mm et 30 mm, en étant de préférence de 10 mm environ.

4. Elément mural préfabriqué selon l'une des revendications précédentes, **caractérisé en ce que** des premier et/ou deuxième grillages en fil métallique réalisés avec une forme ondulée (30, 30') sont au moins partiellement moussés dans le premier et/ou deuxième corps de support (10, 10').

5. Elément mural préfabriqué selon l'une des revendications précédentes, avec un revêtement extérieur (CE) qui jouxte une surface, à orienter vers l'extérieur du bâtiment (E), de la première couche de support (10), dans lequel le revêtement extérieur comprend des plaques décoratives ou un parement.

6. Elément mural préfabriqué selon l'une des revendications précédentes, avec un grillage en fil métallique tridimensionnel (31') respectivement supplémentaire qui s'étend par-delà les sommets d'ondulation du deuxième grillage en fil métallique réalisé avec une forme ondulée (30') et dans lequel des flexibles de chauffage et/ou de refroidissement (90) peuvent être gardés.

7. Elément mural préfabriqué selon l'une des revendications précédentes, dans lequel les premiers et/ou deuxièmes éléments de fixation (40, 40') se composent d'une combinaison respective de vis et butées (41, 42).

8. Elément mural préfabriqué selon la revendication 7, dans lequel la tête d'une vis (41) respective peut être recouverte d'un capuchon en plastique (44) et/ou présente une rondelle (43) en une matière plastique.

9. Elément mural préfabriqué selon l'une des revendications 7 à 8, dans lequel une combinaison respective d'élément de support et de butée (50, 42) est formée et dimensionnée de manière à ce qu'une vis (41) vissée dans la butée (42) n'entre pas en contact avec l'élément de support (50).

10. Elément mural préfabriqué selon l'une des revendications précédentes, avec des flexibles de chauffage et/ou refroidissement (90) qui sont posés dans le revêtement intérieur et/ou extérieur (CI, CE).

11. Elément mural préfabriqué selon la revendication 10, dans lequel les flexibles de chauffage et/ou refroidissement (90) s'étendent sensiblement entre les sommets d'ondulation du premier et/ou deuxième grillage en fil métallique réalisé avec une forme ondulée (30, 30'), lesquels dépassent la surface respective du premier et/ou deuxième corps de support (10, 10').

12. Elément mural préfabriqué selon la revendication 10, dans lequel les flexibles de chauffage et/ou refroidissement (90) sont gardés dans le grillage en fil métallique tridimensionnel (31, 31') respectivement supplémentaire qui s'étend par-delà les sommets d'ondulation des premier et/ou deuxième grillages en fil métallique (30, 30').

13. Bâtiment avec des éléments muraux préfabriqués selon l'une des revendications précédentes, lesquels sont disposés et reliés les uns aux autres de manière à ce que leur premier et/ou deuxième grillage en fil métallique (30, 30') forment une cage de Faraday.
